# FASCICULE DE BREVET EUROPEEN

(11) **EP 4 373 231 B1**
(45) Date de publication et mention de la délivrance du brevet: **11.11.2026**
(21) Numéro de dépôt: 22306698.6
(22) Date de dépôt: 17.11.2022
(51) Int. Cl.: H05K 7/20

(54) **EXTENSION D'ARMOIRE DE SUPERCALCULATEUR**
SUPERRECHNERSCHRANKERWEITERUNG
SUPERCOMPUTER CABINET EXTENSION

(43) Date de publication de la demande: 22.05.2024
(73) Titulaire: BULL SAS, 78340 Les Clayes-Sous-Bois (FR)
(72) Inventeur: CHAMPIGNY, Christophe, 78530 Buc (FR); DEMANGE, Fabien, 78260 Achères (FR); ROCHEREAU, Antoine, 49100 Angers (FR); SIEG, Tom, 44690 Maisdon sur Sèvre (FR)
(74) Mandataire: Argyma

(56) Documents cités:
- CN-A- 113 365 477
- US-A1- 2016 066 478
- US-A1- 2018 242 478
- US-A1- 2019 182 989
- US-A1- 2021 251 097

## Description

### [Domaine technique]

La présente invention se rapporte au domaine du refroidissement des lames de calcul et concerne plus particulièrement une extension d'armoire de supercalculateur.

### [Etat de la technique antérieure]

Les lames de calcul pour serveur comprennent généralement des cartes électroniques, comportant notamment des processeurs, qui dégagent de la chaleur et doivent donc être refroidies. Initialement, ces cartes électroniques étaient refroidies par de l'air, notamment dans le cas où ces lames sont assemblées dans des armoires appelées « racks » de taille standard de 60 centimètres de large.

Toutefois, pour des raisons d'efficacité, le refroidissement par circuits de liquide s'est développé dans l'industrie. Pour adapter ce type de circuit sur une armoire existante, il faut y rajouter un circuit de distribution liquide qui prend la forme d'un ensemble de tuyaux, appelés « manifolds », fixés à l'intérieur de la partie arrière de l'armoire et qui assurent la distribution de liquide de refroidissement dans les lames de calcul.

Cependant, l'ensemble des tuyaux peut gêner la sortie des lames pour assurer leur maintenance. En effet, les lames ont une largeur standardisée de 435 mm et l'épaisseur ajoutée de chaque côté par les tuyaux est de 10 cm. La présence des tuyaux complique donc l'extraction des lames, qui peuvent heurter les tuyaux et les endommager, notamment les percer, lors de l'opération.

Il serait donc avantageux de proposer une solution simple, fiable et efficace permettant de remédier au moins en partie à ces inconvénients. Le document US 2019/182989 A1 montre une extension d'armoire de supercalculateur. Le document US 2018/242478 A1 montre aussi une armoire de supercalculateur.

### [Exposé de l'invention]

A cette fin, l'invention a tout d'abord pour objet une extension d'armoire de supercalculateur, ladite armoire présentant une forme parallélépipédique comportant une face avant, une face arrière ouverte et deux parois latérales et étant configurée pour recevoir une pluralité de serveurs superposés verticalement, chaque serveur comprenant au moins une lame de calcul adaptée pour être insérée et retirée dudit serveur par coulissement à travers la face arrière de l'armoire, ladite extension comprenant un cadre d'armature définissant une ouverture traversante rectangulaire et comprenant au moins un support de connexion fluidique monté sur ledit cadre d'armature et comprenant un circuit amont, configuré pour acheminer un liquide réfrigérant jusqu'à une pluralité de connecteurs d'injection configurés pour être reliés chacun via un tuyau flexible dit « froid » à un circuit de refroidissement d'une lame de calcul de l'un des serveurs, et un circuit aval, configuré pour collecter le liquide réfrigérant réchauffé ayant traversé les lames de calcul des serveurs via un tuyau flexible dit « chaud » et une pluralité de connecteurs de collecte, l'extension étant configurée pour être positionnée à l'arrière de l'armoire, notamment contre la face arrière de l'armoire, de sorte que les lames de calcul puissent être extraites à travers l'ouverture rectangulaire traversante définie par le cadre d'armature.

L'extension d'armoire selon l'invention permet de déporter l'au moins un support de connexion fluidique afin d'assurer la fixation des tuyaux du système de refroidissement hors de l'armoire tout en formant un espace suffisamment large pour permettre de retirer les lames de calcul sans entrer en contact avec les tuyaux du système de refroidissement, évitant ainsi de les endommager au passage. L'extension d'armoire selon l'invention est avantageusement adaptable au matériel existant, notamment aux armoires standard de 60 cm. Une solution alternative aurait été d'utiliser une armoire plus grande, par exemple de 80 centimètres. Cependant, une telle solution impliquerait de changer les armoires existantes standards de 60 cm, ce qui présenterait un inconvénient important. En effet, ces armoires standards de 60 cm étant largement répandues, les équipes de productions sont largement formées sur ces armoires. En outre, ces armoires standards de 60 cm présentent l'avantage d'être transportables en étant chargées (c'est-à-dire avec tous ses composants déjà câblées), ce qui évite d'ajouter de la main d'œuvre lors de l'installation chez le client.

Selon un aspect de l'invention, le cadre d'armature s'étend selon un plan en présentant une forme rectangulaire et comprend deux montants verticaux et deux montants horizontaux.

De préférence, l'extension est configurée pour être montée ou fixée sur la face arrière de l'armoire afin de solidariser l'extension à ladite armoire, par exemple à l'aide d'un système de vis, afin de la rendre solidaire de l'armoire et ainsi éviter son déplacement par rapport à ladite armoire.

De préférence encore, l'extension comprend deux supports de connexion fluidique afin de connecter et refroidir davantage de lames de calcul.

De préférence, l'au moins un support de connexion fluidique est monté à l'intérieur du cadre d'armature, c'est-à-dire dans l'espace interne défini entre les montants du cadre d'armature.

Selon l'invention, l'au moins un support de connexion fluidique est monté verticalement sur le cadre d'armature afin de permettre une distribution efficace du liquide réfrigérant. L'au moins un support de connexion fluidique est monté verticalement contre la paroi interne d'un des montants verticaux du cadre d'armature.

De préférence, l'au moins un support de connexion fluidique est fixé sur le cadre d'armature, par exemple à l'aide d'un système de vis, afin de le rendre solidaire du cadre d'armature, par exemple pour pouvoir déplacer ledit cadre d'armature aisément.

Selon un aspect de l'invention, l'au moins un support de connexion fluidique comprend un premier conduit, définissant le circuit amont, et un deuxième conduit, définissant le circuit aval.

De préférence, le premier conduit et le deuxième conduit sont parallèles.

Avantageusement, le premier conduit et/ou le deuxième conduit comprend une pluralité de connecteurs configurés chacun pour recevoir l'extrémité d'un tube flexible de connexion fluidique à une lame de calcul.

Dans une forme de réalisation, les connecteurs du premier conduit et/ou du deuxième conduit s'étendent parallèlement au plan du cadre d'armature.

Dans une autre forme de réalisation, les connecteurs du premier conduit et/ou du deuxième conduit s'étendent orthogonalement au plan du cadre d'armature.

Selon un aspect de l'invention, l'extension comprend au moins un pied de support, de préférence réglable en hauteur, monté sous le cadre d'armature afin de pouvoir positionner précisément l'ouverture rectangulaire traversante devant la face arrière ouverte de l'armoire.

De préférence, l'extension comprend quatre pieds de support afin de renforcer la stabilité du cadre d'armature.

De préférence, le cadre d'armature de l'extension est réalisé en aluminium pour la conduction thermique du matériau. L'aluminium permet d'évacuer efficacement une partie de la chaleur liée à la circulation de liquide réchauffé dans le circuit aval après que le liquide a circulé dans les circuits de la lame de calcul.

Dans une forme de réalisation, l'extension comprend au moins une cale fixée sur le cadre d'armature.

De préférence, l'au moins une cale est fixée sur un montant vertical du cadre d'armature.

L'invention concerne également une armoire étendue de supercalculateur, ladite armoire présentant une forme parallélépipédique et comportant une face avant, une face arrière ouverte et deux parois latérales et étant configurée pour recevoir une pluralité de serveurs superposés verticalement, chaque serveur comprenant au moins une lame de calcul adaptée pour être insérée et retirée dudit serveur par coulissement à travers la face arrière de l'armoire, l'armoire étendue comprenant une extension telle que présentée précédemment positionnée en regard de la face arrière de l'armoire.

De préférence, l'extension est fixée sur la face arrière de ladite armoire afin de les solidariser entre elles.

De préférence encore, le cadre d'armature présente une largeur supérieure à la largeur de l'armoire afin de permettre le retrait des lames de calcul sans endommager les tuyaux flexibles.

Selon un aspect de l'invention, l'armoire étendue comprend une pluralité de serveurs superposés verticalement, chaque serveur comprenant au moins une lame de calcul adaptée pour être insérée et retirée dudit serveur par coulissement à travers la face arrière de l'armoire.

L'invention concerne également un système comprenant au moins deux armoires étendues telle que présentée précédemment et au moins une cale positionnée entre lesdites armoires étendues afin de les espacer et de les aligner entre elles.

L'utilisation de cales permet d'aligner plusieurs armoires comprenant ou non une extension. Ces alignements sont préférables dans la gestion de plusieurs armoires de supercalculateurs dans les centres de calcul.

Avantageusement, l'au moins une cale est fixée sur au moins une paroi d'au moins une armoire.

Avantageusement encore, l'au moins une cale est fixée sur au moins une paroi latérale d'au moins une armoire.

Avantageusement encore, l'au moins une cale est fixée au moins sur l'extension d'armoire.

Avantageusement encore, l'au moins une cale est alignée avec un bord latéral extérieur de l'extension.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 illustre schématiquement une forme de réalisation de l'armoire étendue selon l'invention.
[Fig 2] La figure 2 illustre schématiquement l'armoire de la figure 1.
[Fig 3] La figure 3 illustre schématiquement l'armature de l'extension de l'armoire de la figure 1.
[Fig 4] La figure 4 illustre schématiquement les supports de connexion fluidique de l'extension de la figure 3.
[Fig 5] La figure 5 illustre schématiquement un exemple d'alignement d'armoires selon l'invention.

### [Description des modes de réalisation]

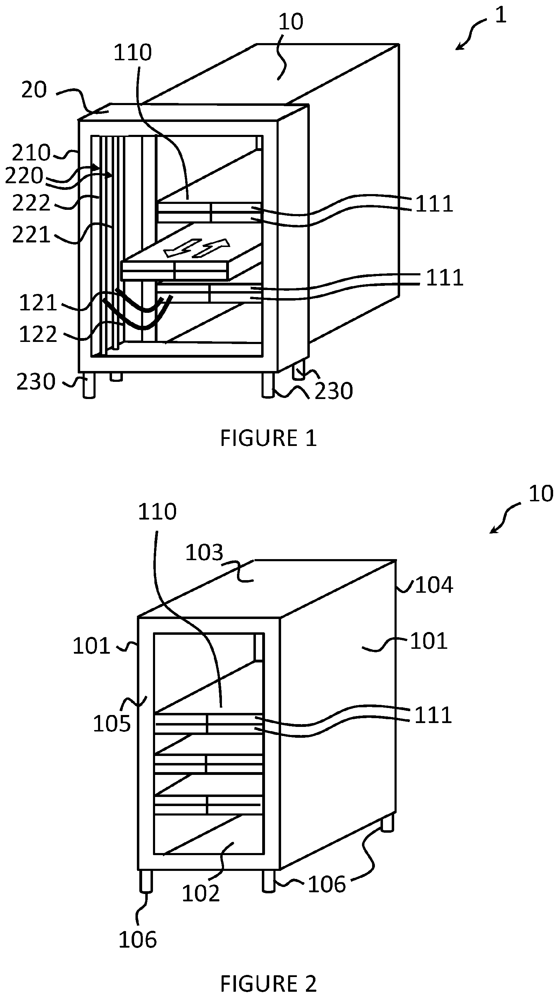

La figure 1 illustre un exemple d'armoire étendue 1 selon l'invention.

### Armoire étendue 1

L'armoire étendue 1 comprend une armoire 10 et une extension 20.

### Armoire 10

En référence à la figure 2, l'armoire 10 présente une forme sensiblement parallélépipédique et comprend deux parois latérales 101, un fond 102, une paroi supérieure 103, une face avant 104, une face arrière 105, des pieds de support 106 et une pluralité de serveurs 110.

Les serveurs 110 sont montés de manière superposée sur des supports fixés entre les parois latérales 101. La face avant 104 peut être munie d'une ou de plusieurs portes (non visibles sur les figures). La face arrière 105 présente une forme rectangulaire ouverte pour permettre l'accès aux serveurs 110 afin notamment d'effectuer leur maintenance.

Dans cet exemple, toujours en référence à la figure 2, chaque serveur 110 comporte quatre lames de calcul 111. Dans une autre forme de réalisation, chaque serveur 110 pourrait comprendre plus ou moins de quatre lames de calcul 111.

Chaque lame de calcul 111 comprend des composants électriques et/ou électroniques, notamment un ou plusieurs processeurs (non représentés) permettant de réaliser des tâches informatiques et de traiter des données.

Chaque lame de calcul 111 comprend un circuit de refroidissement permettant de refroidir les composants électriques et/ou électroniques, notamment les processeurs, à l'aide d'un liquide de refroidissement circulant dans ledit circuit.

A cette fin, chaque lame de calcul 111 comprend un connecteur d'entrée, dit « froid » (non visible), adapté pour recevoir du liquide de refroidissement provenant d'un module de refroidissement (non représenté) externe à l'armoire 10, et un connecteur de sortie, dit « chaud » (non visible), adapté pour évacuer le liquide de refroidissement qui a été réchauffé par les composants électriques et/ou électroniques lors de son passage dans le circuit de refroidissement de la lame de calcul 111 afin de l'acheminer vers le module de refroidissement externe pour qu'il soit refroidi ou régénéré. Un tel module de refroidissement externe étant connu en soi, il ne sera pas davantage détaillé ici.

Un tuyau flexible dit « froid » 121 est relié au connecteur d'entrée froid et un tuyau flexible dit « chaud » 122 est relié au connecteur de sortie chaud.

### Extension 20

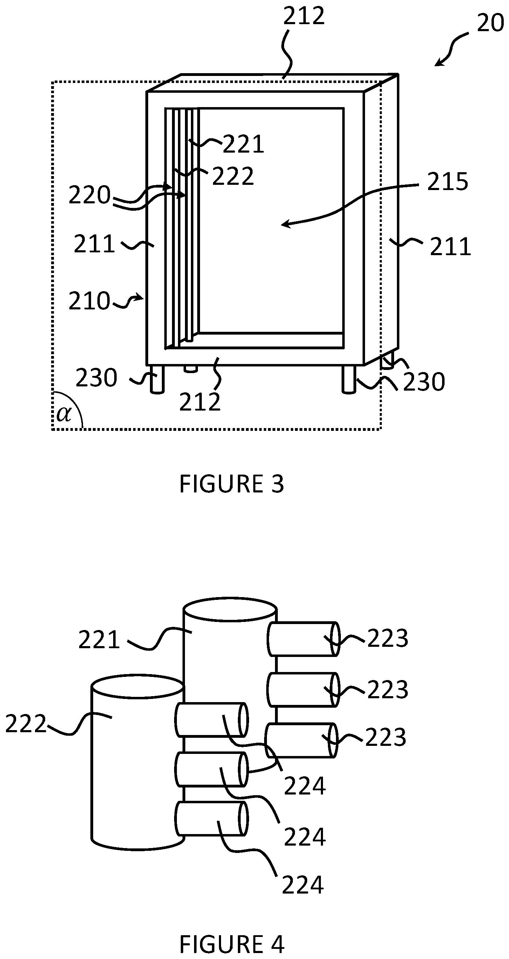

En référence à la figure 3, l'extension 20 comprend un cadre d'armature 210, deux supports de connexion fluidique 220 et des pieds de support 230.

### Cadre d'armature 210

Toujours en référence à la figure 3, le cadre d'armature 210 présente une forme rectangulaire et s'étend dans un plan α parallèle à la face arrière 105 de l'armoire 10.

Le cadre d'armature 210 comprend deux montants 211 verticaux formant les côtés du cadre d'armature 210 et de deux traverses horizontales 212, formant respectivement la partie supérieure et la partie inférieure du cadre d'armature 210.

Le cadre d'armature 210 délimite une ouverture traversante 215 rectangulaire destinée à venir en regard de la face arrière 105 ouverte de l'armoire 10.

Le cadre d'armature 210 présente une largeur supérieure à la largeur de l'armoire 10 afin de permettre le retrait des lames de calcul 111 sans endommager les tuyaux flexibles.

### Support de connexion fluidique 220

En référence aux figures 1 et 3, les supports de connexion fluidique 220 sont disposés verticalement contre la paroi intérieure des montants 211 verticaux du cadre d'armature 210. Autrement dit, les supports de connexion fluidique 220 sont disposés face à face à l'intérieur du cadre d'armature 210. Par souci de clarté, un seul support de connexion fluidique 220 a été représenté sur les figures.

Chaque support de connexion fluidique 220 comporte un premier conduit 221 définissant un circuit amont d'acheminement du liquide de refroidissement froid provenant du module de refroidissement externe et un deuxième conduit 222 définissant un circuit aval d'évacuation du liquide de refroidissement réchauffé à destination du module de refroidissement externe.

Comme illustré sur la figure 1, le premier conduit 221 et le deuxième conduit 222 s'étendent verticalement dans le cadre d'armature 210 sur sensiblement la hauteur des serveurs 110 afin d'alimenter l'ensemble des lames de calcul 111 en liquide réfrigérant, par exemple de l'eau.

Le premier conduit 221 et le deuxième conduit 222 peuvent être réalisés en métal, par exemple en acier.

Dans un autre mode de réalisation, le ou les supports de connexion fluidique pourraient être montés horizontalement sur l'une des traverses horizontales 212 du cadre d'armature 210.

En référence à la figure 4, le premier conduit 221 comprend une pluralité de connecteurs d'injection 223 sur lesquels sont connectés les tuyaux flexibles froids 121 qui permettent de raccorder les lames de calcul 110 au premier conduit 221.

Le deuxième conduit 222 comprend une pluralité de connecteurs de collecte 224 sur lesquels sont connectés les tuyaux flexibles chauds 122 qui permettent de raccorder les lames de calcul 110 au deuxième conduit 222.

Le premier conduit 221 est relié au module de refroidissement externe afin de recevoir le liquide de refroidissement froid.

Le deuxième conduit 222 est relié au module de refroidissement externe afin de d'évacuer le liquide de refroidissement réchauffé.

De préférence, le minimum entre la largeur de l'ouverture traversante 215 et la largeur entre les connecteurs 223, 224 des deux supports de connexion fluidique 220 verticaux est supérieur à la largeur d'un serveur 110 augmentée d'au moins 20 cm afin de s'assurer du passage des lames de calcul 111 sans endommager les tuyaux flexibles froids 121 et les tuyaux flexibles chauds 122.

### Pieds de support 230

Dans cet exemple non limitatif, l'extension 20 comprend quatre pieds de support 230, de préférence réglables.

Les pieds de support 230 permettent de positionner l'ouverture traversante 215 rectangulaire exactement en regard de la face arrière 105 ouverte de l'armoire 10 de sorte à pouvoir retirer les lames de calcul 111 à travers ladite ouverture traversante 215.

Dans une autre forme de réalisation, l'extension 20 pourrait comprendre plus ou moins de quatre pieds de support 230.

De préférence, chaque pied de support 230 est muni d'un patin en caoutchouc pour éviter tout déplacement de l'extension 20 une fois installée.

### Système 100

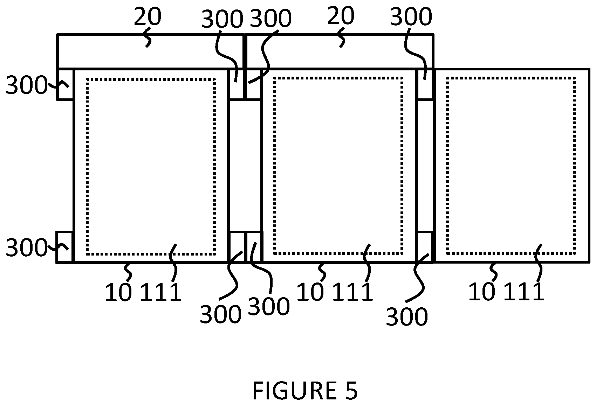

La figure 5 représente un système 100 formé de trois armoires 10 dont deux sont munies d'une extension 20 en vue de dessus.

Les armoires 10 sont disposées côte à côte en étant alignées les unes avec les autres.

Des cales 300 sont placées entre les armoires 10 afin de faciliter cet alignement tout en permettant de caler les armoires 10 les unes contre les autres. Ces cales 300 se présentent sous la forme de poutres de forme parallélépipèdique disposées verticalement entre les armoires 10 et dont la largeur est égale à la largeur de l'extension dépassant de la paroi latérale 101 de l'armoire 10.

Les cales 300 peuvent être fixées sur les parois latérales 101 des armoires 10 et/ou sur le cadre d'armature 210 de l'extension 20.

### Exemple de mise en œuvre

L'armoire 10 est installée dans un centre de calcul, les serveurs 110 et les lames de calcul 111 étant montées à l'intérieur.

L'extension 20 est positionnée sur la face arrière 105 de l'armoire 10 et la hauteur de l'extension 20 est ajustée à celle de l'armoire 10 si besoin au moyen des pieds 230 réglables de sorte que ladite face arrière 105 de l'armoire 10 soit entièrement visible et accessible lorsque les tuyaux flexibles 121, 122 sont reliés entre les connecteurs 123 et les lames de calcul 111.

De préférence, l'extension 20 est fixée sur la partie arrière de l'armoire 10, par exemple en vissant le cadre d'armature 210 sur des supports préexistants de l'armoire 10 adaptés pour recevoir des portes arrières. Dans un autre mode de réalisation, l'extension 20 pourrait être fixée à l'armoire 10 par tout autre moyen de fixation adapté (crochets, tiges, etc.).

Pour chaque lame de calcul 111 de l'armoire 10, un tuyau flexible froid 121 est relié d'une part au connecteur d'entrée de ladite lame de calcul 111 et d'autre part à un connecteur 223 du premier conduit 221. De même, pour chaque lame de calcul 111 de l'armoire 10, un tuyau flexible chaud 122 est relié d'une part au connecteur de sortie de ladite lame de calcul 111 et d'autre part à un connecteur 224 du deuxième conduit 222

La largeur de l'ouverture rectangulaire traversante définie entre les montants du cadre d'armature 210 permet la réalisation des opérations de maintenance des lames de calcul 111, notamment le retrait et l'insertion des lames de calcul 111 de l'armoire 10, sans heurter les tuyaux flexibles 121 et 122 ou les connecteurs 223 et 224.

De préférence, la largeur de l'ouverture rectangulaire traversante 215 est supérieure ou égale à la largeur de l'ouverture de l'armoire 10, qui peut par exemple être de 19 pouces (i.e. 48,26 cm) de manière standard.

Un exemple non limitatif d'installation d'un système 100 d'armoires 10 selon l'invention va maintenant être décrit.

Plusieurs armoires 10 étendues selon l'invention peuvent être disposées côte-à-côte, comme illustré sur la figure 5. Des cales 300 peuvent ensuite être placées entre les armoires 10 deux à deux en étant fixées sur l'armoire 10 et/ou sur l'extension 20, permettent alors d'aligner et d'espacer les armoires 10 de manière uniforme.

L'invention permet l'utilisation d'armoire 10 de dimensions standards, par exemple de 60 cm de large, sans risque d'endommager les tuyaux flexibles lors du retrait ou de l'insertion des lames de calcul 111.

## Revendications

1. Extension (20) d'armoire (10) de supercalculateur, ladite armoire (10) présentant une forme parallélépipédique comportant une face avant (104), une face arrière (105) ouverte et deux parois latérales (101) et étant configurée pour recevoir une pluralité de serveurs (110) superposés verticalement, chaque serveur (110) comprenant au moins une lame de calcul (111) adaptée pour être insérée et retirée dudit serveur (110) par coulissement à travers la face arrière (105) de l'armoire (10), ladite extension (20) comprenant un cadre d'armature (210) définissant une ouverture traversante (215) rectangulaire et comprenant au moins un support de connexion fluidique (220) monté sur ledit cadre d'armature (210) et comprenant un circuit amont, configuré pour acheminer un liquide réfrigérant jusqu'à une pluralité de connecteurs (223) configurés pour être reliés chacun via un tuyau flexible dit « froid » (121) à un circuit de refroidissement d'une lame de calcul (111) de l'un des serveurs (110), et un circuit aval, configuré pour collecter le liquide réfrigérant réchauffé ayant traversé les lames de calcul (111) des serveurs (110) via un tuyau flexible dit « chaud » (122), et une pluralité de connecteurs de collecte (224), l'extension (20) étant configurée pour être positionnée à l'arrière de l'armoire (10), **caracterisé en ce que** l'au moins un support de connexion fluidique (220) est disposé verticalement à l'intérieur du cadre d'armature (210) contre la paroi intérieure d'un montant (211) vertical du cadre d'armature (210).

2. Extension (20) selon la revendication 1, ladite extension (20) étant configurée pour être fixée sur la face arrière (105) de l'armoire (10).

3. Extension (20) selon l'une quelconque des revendications précédentes, dans laquelle l'au moins un support de connexion fluidique (220) est monté verticalement dans le cadre d'armature (210).

4. Extension (20) selon l'une quelconque des revendications précédentes, dans laquelle l'au moins un support de connexion fluidique (220) est fixé à l'intérieur du cadre d'armature (210).

5. Extension (20) selon l'une quelconque des revendications précédentes, dans laquelle l'au moins un support de connexion fluidique (220) est monté verticalement sur le cadre d'armature (210).

6. Extension (20) selon l'une quelconque des revendications précédentes, ladite extension (20) comprenant au moins un pied de support (230) monté sous le cadre d'armature (210).

7. Extension (20) selon la revendication précédente, dans laquelle ladite extension (20) comprend quatre pieds de support (230).

8. Extension (20) selon l'une quelconque des revendications précédentes, dans laquelle l'au moins un support de connexion fluidique (220) comprend un premier conduit (221), définissant le circuit amont, et un deuxième conduit (222), définissant le circuit aval, les connecteurs du premier conduit (221) et du deuxième conduit (222) s'étendant parallèlement au plan du cadre d'armature (210).

9. Extension (20) selon l'une quelconque des revendications précédentes, dans laquelle le cadre d'armature (210) est réalisé en aluminium.

10. Armoire étendue (1) de supercalculateur, ladite armoire étendue (1) comprenant une armoire (10) présentant une forme parallélépipédique et comportant une face avant (104), une face arrière (105) ouverte et deux parois latérales (101) et étant configurée pour recevoir une pluralité de serveurs (110) superposés verticalement, chaque serveur (110) comprenant au moins une lame de calcul (111) adaptée pour être insérée et retirée dudit serveur (110) par coulissement à travers la face arrière (105) de l'armoire (10), l'armoire étendue (1) comprenant une extension selon l'une quelconque des revendications précédentes positionnée en regard de la face arrière (105) de l'armoire (10).

11. Armoire étendue (1) selon la revendication précédente, dans laquelle l'extension (20) est fixée sur la face arrière (105) de ladite armoire (10).

12. Armoire étendue (1) selon l'une quelconque des revendications 10 ou 11, dans lequel le cadre d'armature (210) présente une largeur supérieure à la largeur de l'armoire (10).

13. Système (100) comprenant au moins deux armoires étendues (1) selon l'une quelconque des revendications 10 à 12 et au moins une cale (300) positionnée entre lesdites armoires étendues (1).

14. Système (100) selon la revendication précédente, dans lequel l'au moins une cale (300) est fixée sur au moins une paroi d'au moins une armoire (10).

15. Système (100) selon la revendication précédente, dans lequel l'au moins une cale (300) est fixée sur au moins une paroi latérale (101) d'au moins une armoire (10).

## Patentansprüche

1. Erweiterung (20) eines Schranks (10) eines Superrechners, wobei der Schrank (10) eine quaderförmige Form aufweist, die eine Vorderseite (104), eine offene Rückseite (105) und zwei Seitenwände (101) umfasst, und konfiguriert ist, um eine Vielzahl von vertikal übereinander angeordneten Servern (110) aufzunehmen, wobei jeder Server (110) mindestens einen Recheneinschub (111) umfasst, der ausgebildet ist, um durch Hindurchschieben durch die Rückseite (105) des Schranks (10) in den Server (110) eingeführt und daraus entfernt zu werden, wobei die Erweiterung (20) einen Tragrahmen (210) umfasst, der eine rechteckige Durchgangsöffnung (215) definiert und mindestens einen Fluidanschlussträger (220) umfasst, der auf dem Tragrahmen (210) montiert ist und einen stromaufwärtigen Kreislauf umfasst, der konfiguriert ist, um eine Kühlflüssigkeit bis zu einer Vielzahl von Verbindern (223) zu leiten, die konfiguriert sind, um jeweils über einen "kalten" flexiblen Schlauch (121) mit einem Kühlkreislauf eines Recheneinschubs (111) eines der Server (110) verbunden zu werden, und einen stromabwärtigen Kreislauf, der konfiguriert ist, um die erwärmte Kühlflüssigkeit, welche die Recheneinschübe (111) der Server (110) durchströmt hat, über einen "heißen" flexiblen Schlauch (122) zu sammeln, und eine Vielzahl von Sammelverbindern (224), wobei die Erweiterung (20) konfiguriert ist, um an der Rückseite des Schranks (10) positioniert zu werden, **dadurch gekennzeichnet, dass** der mindestens eine Fluidanschlussträger (220) vertikal im Inneren des Tragrahmens (210) gegen die Innenwand eines vertikalen Pfostens (211) des Tragrahmens (210) angeordnet ist.

2. Erweiterung (20) nach Anspruch 1, wobei die Erweiterung (20) konfiguriert ist, um auf der Rückseite (105) des Schranks (10) befestigt zu werden.

3. Erweiterung (20) nach einem der vorstehenden Ansprüche, wobei der mindestens eine Fluidanschlussträger (220) vertikal in dem Tragrahmen (210) montiert ist.

4. Erweiterung (20) nach einem der vorstehenden Ansprüche, wobei der mindestens eine Fluidanschlussträger (220) im Inneren des Tragrahmens (210) befestigt ist.

5. Erweiterung (20) nach einem der vorstehenden Ansprüche, wobei der mindestens eine Fluidanschlussträger (220) vertikal auf dem Tragrahmen (210) montiert ist.

6. Erweiterung (20) nach einem der vorstehenden Ansprüche, wobei die Erweiterung (20) mindestens einen unter dem Tragrahmen (210) montierten Stützfuß (230) umfasst.

7. Erweiterung (20) nach dem vorstehenden Anspruch, wobei die Erweiterung (20) vier Stützfüße (230) umfasst.

8. Erweiterung (20) nach einem der vorstehenden Ansprüche, wobei der mindestens eine Fluidanschlussträger (220) eine erste Leitung (221), die den stromaufwärtigen Kreislauf definiert, und eine zweite Leitung (222), die den stromabwärtigen Kreislauf definiert, umfasst, wobei sich die Verbinder der ersten Leitung (221) und der zweiten Leitung (222) parallel zu der Ebene des Tragrahmens (210) erstrecken.

9. Erweiterung (20) nach einem der vorstehenden Ansprüche, wobei der Tragrahmen (210) aus Aluminium hergestellt ist.

10. Erweiterter Schrank (1) eines Superrechners, wobei der erweiterte Schrank (1) einen Schrank (10) umfasst, der eine quaderförmige Form aufweist und eine Vorderseite (104), eine offene Rückseite (105) und zwei Seitenwände (101) umfasst und konfiguriert ist, um eine Vielzahl von vertikal übereinander angeordneten Servern (110) aufzunehmen, wobei jeder Server (110) mindestens einen Recheneinschub (111) umfasst, der ausgebildet ist, um durch Hindurchschieben durch die Rückseite (105) des Schranks (10) in den Server (110) eingeführt und daraus entfernt zu werden, wobei der erweiterte Schrank (1) eine Erweiterung nach einem der vorstehenden Ansprüche umfasst, die gegenüber der Rückseite (105) des Schranks (10) positioniert ist.

11. Erweiterter Schrank (1) nach dem vorstehenden Anspruch, wobei die Erweiterung (20) auf der Rückseite (105) des Schranks (10) befestigt ist.

12. Erweiterter Schrank (1) nach einem der Ansprüche 10 oder 11, wobei der Tragrahmen (210) eine Breite aufweist, die größer als die Breite des Schranks (10) ist.

13. System (100), umfassend mindestens zwei erweiterte Schränke (1) nach einem der Ansprüche 10 bis 12 und mindestens einen Keil (300), der zwischen den erweiterten Schränken (1) positioniert ist.

14. System (100) nach dem vorstehenden Anspruch, wobei der mindestens eine Keil (300) auf mindestens einer Wand mindestens eines Schranks (10) befestigt ist.

15. System (100) nach dem vorstehenden Anspruch, wobei der mindestens eine Keil (300) auf mindestens einer Seitenwand (101) mindestens eines Schranks (10) befestigt ist.

## Claims

1. An extension (20) for a supercomputer cabinet (10), said cabinet (10) having a parallelepiped shape including a front face (104), an open rear face (105), and two side walls (101), and being configured to accommodate a plurality of vertically stacked servers (110), each server (110) comprising at least one compute blade (111) suitable for being inserted into and removed from said server (110) by sliding through the rear face (105) of the cabinet (10), said extension (20) comprising a reinforcement frame (210) defining a rectangular through-opening (215) and comprising at least one fluid connection support (220) mounted on said reinforcement frame (210) and comprising an upstream circuit configured to convey a cooling fluid to a plurality of connectors (223), each of which is configured to be connected via a so-called "cold" flexible hose (121) to a cooling circuit of a compute blade (111) of one of the servers (110), and a downstream circuit, configured to collect the heated cooling fluid that has passed through the compute blades (111) of the servers (110) via a so-called "hot" flexible hose (122), and a plurality of collection connectors (224), the extension (20) being configured to be positioned at the rear of the cabinet (10), **characterized in that** the at least one fluid connection support (220) is arranged vertically inside the reinforcement frame (210) against the inner wall of a vertical stud (211) of the reinforcement frame (210).

2. The extension (20) according to claim 1, said extension (20) being configured to be attached to the rear face (105) of the cabinet (10).

3. The extension (20) according to either of the preceding claims, wherein the at least one fluid connection support (220) is mounted vertically in the reinforcement frame (210).

4. The extension (20) according to any of the preceding claims, wherein the at least one fluid connection support (220) is attached inside the reinforcement frame (210).

5. The extension (20) according to any of the preceding claims, wherein the at least one fluid connection support (220) is mounted vertically on the reinforcement frame (210).

6. The extension (20) according to any of the preceding claims, said extension (20) comprising at least one support foot (230) mounted beneath the reinforcement frame (210).

7. The extension (20) according to the preceding claim, wherein said extension (20) comprises four support feet (230).

8. The extension (20) according to any of the preceding claims, wherein the at least one fluid connection support (220) comprises a first conduit (221), defining the upstream circuit, and a second conduit (222), defining the downstream circuit, the connectors of the first conduit (221) and of the second conduit (222) extending parallel to the plane of the reinforcement frame (210).

9. The extension (20) according to any of the preceding claims, wherein the reinforcement frame (210) is made of aluminum.

10. An extended supercomputer cabinet (1), said extended cabinet (1) comprising a cabinet (10) having a parallelepiped shape and including a front face (104), an open rear face (105), and two side walls (101), and being configured to accommodate a plurality of vertically stacked servers (110), each server (110) comprising at least one compute blade (111) suitable for being inserted into and removed from said server (110) by sliding through the rear face (105) of the cabinet (10), the extended cabinet (1) comprising an extension according to any of the preceding claims positioned opposite the rear face (105) of the cabinet (10).

11. The extended cabinet (1) according to the preceding claim, wherein the extension (20) is attached to the rear face (105) of said cabinet (10).

12. The extended cabinet (1) according to any of claims 10 or 11, wherein the reinforcement frame (210) has a width greater than the width of the cabinet (10).

13. A system (100) comprising at least two extended cabinets (1) according to any of claims 10 to 12 and at least one spacer (300) positioned between said extended cabinets (1).

14. The system (100) according to the preceding claim, wherein the at least one spacer (300) is attached to at least one wall of at least one cabinet (10).

15. The system (100) according to the preceding claim, wherein the at least one spacer (300) is attached to at least one side wall (101) of at least one cabinet (10).
